(19) Europäisches Patentamt / European Patent Office / Office européen des brevets

(11) **EP 4 063 044 A1**

(12) **EUROPEAN PATENT APPLICATION**
published in accordance with Art. 153(4) EPC

(43) Date of publication:
**28.09.2022 Bulletin 2022/39**

(21) Application number: **20889717.3**

(22) Date of filing: **20.11.2020**

(51) International Patent Classification (IPC):
**B22F 7/08** (2006.01)      **B22F 9/00** (2006.01)
**B82Y 30/00** (2011.01)      **H01L 21/52** (2006.01)

(52) Cooperative Patent Classification (CPC):
**B22F 7/08; B22F 9/00; B82Y 30/00; H01L 21/52**

(86) International application number:
**PCT/JP2020/043381**

(87) International publication number:
**WO 2021/100851 (27.05.2021 Gazette 2021/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **22.11.2019 JP 2019211632**

(71) Applicant: **LINTEC CORPORATION**
**Itabashi-ku**
**Tokyo 173-0001 (JP)**

(72) Inventors:
• **NAKAYAMA, Hidekazu**
**Tokyo 173-0001 (JP)**
• **ICHIKAWA, Isao**
**Tokyo 173-0001 (JP)**
• **SATO, Yosuke**
**Tokyo 173-0001 (JP)**

(74) Representative: **V.O.**
**P.O. Box 87930**
**2508 DH Den Haag (NL)**

(54) **FILM-LIKE FIRING MATERIAL, FILM-LIKE FIRING MATERIAL WITH SUPPORT SHEET, MULTILAYER BODY, AND METHOD FOR PRODUCING DEVICE**

(57)     The present invention relates to a film-shaped firing material (1) which contains: sinterable metal particles (10); a binder component (20) that is a solid at room temperature; and a liquid component (30) that is a liquid at room temperature, the liquid component having a boiling point from 300 to 450°C.

FIG. 1

**Description**

[Technical Field]

The present invention relates to a film-shaped firing material, a film-shaped firing material with a support sheet, a laminate, and a method for producing a device.

This application claims priority from the Japanese Patent Application No. 2019-211632, filed in Japan on November 22, 2019, the contents of which are incorporated herein by reference.

[Background Art]

In recent years, in association with an increase in the voltage and current levels in automobiles, air conditioners, personal computers, and the like, the demand for power semiconductor elements (power devices) installed in these has been increasing. Because power semiconductor elements are used under high voltage and high current conditions, the generation of heat from the semiconductor element tends to be problematic.

To dissipate the heat generated from the semiconductor element, a heat sink has been sometimes attached around the semiconductor element in the art. However, insufficient thermal conductivity at a joint portion between the heat sink and the semiconductor element may hinder efficient heat dissipation.

Patent Document 1 for example discloses, as a bonding material having excellent thermal conductivity, a paste-like metal particulate composition in which specific heat-sinterable metal particles, a specific polymeric dispersing agent, and a specific volatile dispersion medium are mixed. When sintered, the composition becomes a solid metal having excellent thermal conductivity.

[Citation List]

[Patent Literature]

Patent Document 1: JP 2014-111800 A

[Summary of Invention]

[Technical Problem]

However, in a case in which a firing material is paste-like as in Patent Document 1, it is difficult to achieve a uniform thickness of the paste when applied, and the thickness stability tends to be poor. Firing materials are typically provided as paste-like compositions, but the present inventors conceived of the idea of solving the problem of thickness stability by providing the firing material in the shape of a film.

In order to achieve a film-shaped firing material, a binder component may be blended into the firing material, and then the firing material may be formed into a film shape. Considering the sublimability during firing, the film-shaped firing material preferably has a high content of sinterable metal particles and a low content of the binder component.

The firing material is used, for example, for sinter bonding a chip, obtained by dividing a semiconductor wafer into individual pieces via dicing, and a substrate. In addition, when a support sheet is provided on one side (surface) of the film-shaped firing material, the film-shaped firing material can be used as a dicing sheet that is used when dividing a semiconductor wafer into individual chips. Furthermore, the film-shaped firing material can be processed into the same shape as a chip by being divided into individual pieces together with a semiconductor wafer by the use of a blade or the like.

However, when the content of the binder component in the film-shaped firing material is low, the adhesive force between the film-shaped firing material and the support sheet tends to be insufficient, leading to dicing defects. The inventors of the present application have investigated improving the adhesive force between the film-shaped firing material and the support sheet by increasing the content of the binder component in the film-shaped firing material. When the content of the binder component was increased, it was confirmed that the adhesive force was improved; however, it was found that the film-shaped firing material exuded from between a chip and a substrate when the chip, an individual piece obtained via dicing, and the substrate were subjected to sinter bonding with the film-shaped firing material interposed therebetween. When the film-shaped firing material exudes out from between the chip and the substrate during sinter bonding, the thickness of the sintered body after sintering is uneven. In addition, if the exuded film-shaped firing material extends to other circuit wirings on the surface of the substrate, the electrical characteristics may be impaired due to electrical connection failure or the like.

In light of the foregoing, an object of the present invention is to provide a film-shaped firing material, a film-shaped firing material with a support sheet, a laminate, and a method for producing a device employing the film-shaped firing material, the film-shaped firing material with a support sheet, and the laminate, wherein the film-shaped firing material has sufficient adhesive force with a support sheet, has excellent dicing suitability, and does not easily exude from between a semiconductor chip and a substrate when the semiconductor chip and the substrate are subjected to sinter bonding.

[Solution to Problem]

The present invention has the following aspects.

[1] A film-shaped firing material containing sinterable metal particles, a binder component that is a solid at room temperature, and a liquid component that is a liquid at room temperature, the liquid component having a boiling point from 300 to 450°C.

[2] A film-shaped firing material with a support sheet, including the film-shaped firing material described in [1] and a support sheet provided on at least one side of the film-shaped firing material.

[3] The film-shaped firing material with a support sheet according to [2], wherein the support sheet includes a pressure sensitive adhesive layer provided on a base material film, and the film-shaped firing material is provided on the pressure sensitive adhesive layer.

[4] A laminate, in which the film-shaped firing material with a support sheet described in [2] or [3] is affixed to a wafer, the laminate including the support sheet, the film-shaped firing material, and the wafer, which are laminated in this order.

[5] A method for producing a device including:

affixing a semiconductor chip with film-shaped firing material to a surface of a substrate, the semiconductor chip with a film-shaped firing material being obtained by affixing a semiconductor chip to the film-shaped firing material described in [1]; and
firing and pressurizing the film-shaped firing material of the semiconductor chip to bond the semiconductor chip with the film-shaped firing material to the substrate.

[6] A method for producing a device including:

dicing the semiconductor wafer and the film-shaped firing material of the laminate described in [4];
peeling the diced film-shaped firing material off from the support sheet to obtain a semiconductor chip with the film-shaped firing material;
affixing the semiconductor chip with the film-shaped firing material to a surface of a substrate, and
firing and pressurizing the film firing material of the semiconductor chip with the film-shaped firing material to bond the semiconductor chip with the film-shaped firing material to the substrate.

[Advantageous Effects of Invention]

According to the present invention, it is possible to provide a film-shaped firing material, a film-shaped firing material with a support sheet, and a laminate, wherein the film-shaped firing material has sufficient adhesive force with the support sheet, has excellent dicing suitability, and does not easily exude from between a semiconductor chip and a substrate when the chip and the substrate are subjected to sinter bonding. Furthermore, a method for producing a device employing the film-shaped firing material, the film-shaped firing material with a support sheet, and the laminate can be provided.

[Brief Description of Drawings]

Fig. 1 is a cross-sectional view schematically illustrating a film-shaped firing material according to an embodiment of the present invention.
Fig. 2 is a cross-sectional view schematically illustrating a state in which the film-shaped firing material with a support sheet according to an embodiment of the present invention is affixed to a ring frame.
Fig. 3 is a cross-sectional view schematically illustrating a state in which the film-shaped firing material with a support sheet according to an embodiment of the present invention is affixed to a ring frame.
Fig. 4 is a perspective view schematically illustrating a state in which the film-shaped firing material with a support sheet according to an embodiment of the present invention is affixed to a ring frame.

Fig. 5 is a cross-sectional view schematically illustrating a laminate according to an embodiment of the present invention.

Fig. 6 is a cross-sectional view schematically illustrating a method for producing a device according to an embodiment of the present invention.

[Description of Embodiments]

One embodiment of the present invention will be described below with reference, as appropriate, to the drawings.

In figures used in the following descriptions, a main part may be enlarged for convenience to facilitate understanding of features of the present invention, and a dimension ratio or the like of each component is not necessarily identical to the actual one.

<<Film-shaped firing material>>

A film-shaped firing material according to the present embodiment contains sinterable metal particles, a binder component that is a solid at room temperature, and a liquid component that is a liquid at room temperature, the liquid component having a boiling point of from 300 to 450°C.

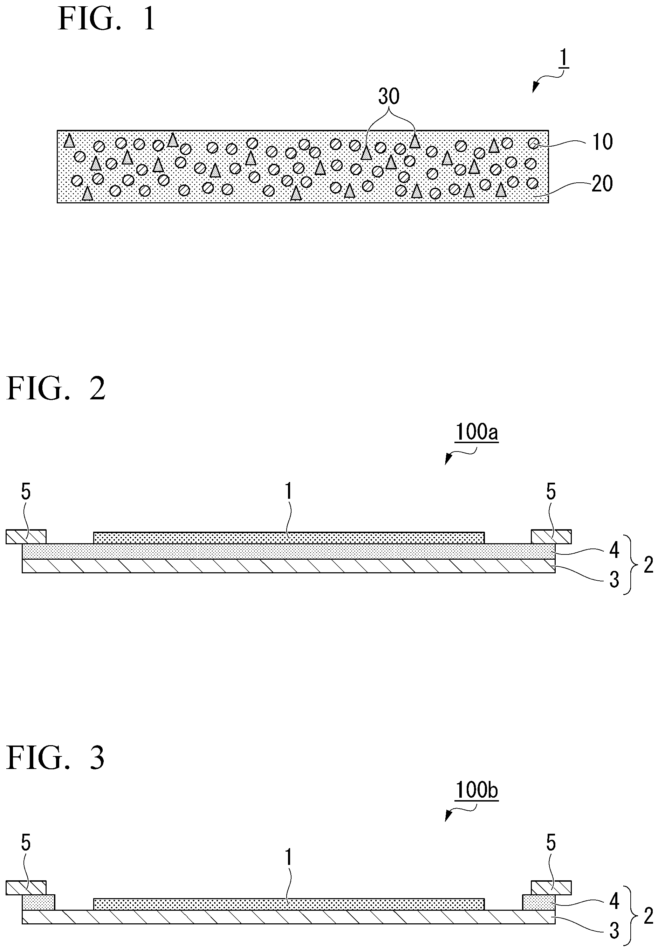

Fig. 1 is a cross-sectional view schematically illustrating a film-shaped firing material according to the present embodiment. A film-shaped firing material 1 contains sinterable metal particles 10, a binder component 20, and a liquid component 30.

The film-shaped firing material may be formed from one layer (single layer) or may be formed from a plurality of layers of two or more. When the film-shaped firing material is made from a plurality of layers, the plurality of layers may be mutually the same or different, and combinations of these plurality of layers are not particularly limited as long as the effects of the present invention are not impaired.

Note that the present specification is not limited to the case of a film-shaped firing material, and the matter of "the plurality of layers may be mutually the same or different" means that "all layers may be the same, all layers may be different, or only some of the layers may be the same", and the matter of "the plurality of layers are mutually different" means that "the constituent materials of each layer and/or the blending ratios of the constituent materials and/or the thickness of the layers differs from that of the others".

A thickness of the film-shaped firing material before firing is not limited, but is preferably from 10 to 200 $\mu$m, more preferably from 20 to 150 $\mu$m, and even more preferably from 30 to 90 $\mu$m.

Here, "thickness of the film-shaped firing material" refers to the overall thickness of the film-shaped firing material, and, for example, the thickness of a film-shaped firing material made from a plurality of layers refers to the total thickness of all layers configuring the film-shaped firing material.

In the present specification, "thickness" can be obtained as a value represented by an average of thickness measured at 5 randomly selected locations using a constant pressure thickness meter in accordance with JIS K7130.

(Release film)

The film-shaped firing material can be provided with a release film laminated thereon. When used, the release film may be peeled off, and the film-shaped firing material then placed on a target object to be sintered and bonded. The release film also functions as a protective film to prevent damage or dirt adhesion to the film-shaped firing material. The release film may be provided on at least one side of the film-shaped firing material, and may be provided on both sides of the film-shaped firing material.

The release film may be, for example, a transparent film such as a polyethylene film, a polypropylene film, a polybutene film, a polybutadiene film, a polymethylpentene film, a polyvinyl chloride film, a vinyl chloride copolymer film, a polyethylene terephthalate film, a polyethylene naphthalate film, a polybutylene terephthalate film, a polyurethane film, an ethylene vinyl acetate copolymer film, an ionomer resin film, an ethylene-(meth)acrylic acid copolymer film, an ethylene-(meth)acrylate copolymer film, a polystyrene film, a polycarbonate film, a polyimide film, and a fluororesin film. Crosslinked films of these may also be used. Laminated films of these may also be used. In addition, films obtained by coloring these, non-transparent films thereof, or the like can also be used. Examples of the release agent include silicone-based release agents, fluorine-based release agents, olefin-based release agents, alkyd-based release agents, and long-chain alkyl group-containing carbamates.

The approximate thickness of the release film is typically from 10 to 500 $\mu$m, preferably from 15 to 300 $\mu$m, and particularly preferably from 20 to 250 $\mu$m.

<Sinterable metal particles>

The film-shaped firing material according to the present embodiment contains sinterable metal particles.

The sinterable metal particles are metal particles that can be formed into a sintered body when the particles are melted and bonded to each other by heat-treating the film-shaped firing material at a temperature higher than or equal to the melting point of the metal particles. By forming the sintered body, the film-shaped firing material and an article fired in contact therewith can be sintered and bonded. Specifically, the chip and the substrate can be sintered and bonded together through the film-shaped firing material.

Sinterable metal particles are particles that are easier to sinter than non-sinterable metal particles described below.

Examples of the metal species of the sinterable metal particles include silver, gold, copper, iron, nickel, aluminum, silicon, palladium, platinum, titanium, and barium. Examples of the sinterable metal particles include metals of the above metal species and oxides or alloys thereof, and silver and silver oxide are preferable. Furthermore, the sinterable metal particles may be an oxide containing two or more of the above metal species such as barium titanate. The sinterable metal particles may contain only one type of sinterable metal particles or a combination of two or more types of sinterable metal particles.

The sinterable metal particles are preferably silver nanoparticles, which are nano-sized silver particles.

In the present specification, the term "sinterable metal particles" specifically refers to particles containing a metal element having a particle size of 100 nm or less.

A particle size of the sinterable metal particles contained in the film-shaped firing material is not limited as long as it is 100 nm or less and is a value at which the sinterable metal particles can exhibit the sinterability, but the particle size of the sinterable metal particles may be 50 nm or less, or 30 nm or less. Note that the particle diameter of the metal particles contained in the film-shaped firing material is the projected area circle equivalent diameter of the particle diameter of the metal particles observed with an electron microscope. Metal particles that fall within the above range of particle diameters are preferable because they have excellent sinterability.

With regard to the particle diameter of the sinterable metal particles contained in the film-shaped firing material, the number-average particle diameter of metal particles observed with an electron microscope, the number-average particle diameter being determined with respect to particles having a projected area circle equivalent diameter of 100 nm or less, may be from 0.1 to 95 nm, may be from 0.3 to 50 nm, or may be from 0.5 to 30 nm. Note that the quantity of metal particles to be measured is 100 or more per one film-shaped firing material, with the metal particles thereof being randomly selected. For example, the metal particles to be measured are 100 metal particles randomly selected per film-shaped firing material.

In addition to the metal particles (sinterable metal particles) having a particle size of 100 nm or less, non-sinterable metal particles with a particle size of greater than 100 nm other than the sinterable metal particles may be further blended in the film-shaped firing material according to the present embodiment. The non-sinterable metal particles are particles that are more difficult to sinter than the aforementioned sinterable metal particles. In the present specification, the term "non-sinterable metal particles" specifically refers to particles containing a metal element having a particle size of greater than 100 nm. With regard to the particle diameter of the non-sinterable metal particles having a particle diameter greater than 100 nm, the number-average particle diameter of metal particles observed with an electron microscope, the number-average particle diameter being determined with respect to particles having a projected area circle equivalent diameter of greater than 100 nm, may be greater than 150 nm and less than or equal to 50000 nm, may be from 150 to 10000 nm, or may be from 180 to 5000 nm. Note that the quantity of metal particles to be measured is 100 or more per one film-shaped firing material, with the metal particles thereof being randomly selected. For example, the metal particles to be measured are 100 metal particles randomly selected per film-shaped firing material.

Examples of the metal species of the non-sinterable metal particles having a particle size of greater than 100 nm include the same as those exemplified as the metal species of the aforementioned sinterable metal particles. The non-sinterable metal particles are preferably silver, copper and oxides thereof. The non-sinterable metal particles may contain only one type of non-sinterable metal particles or a combination of two or more types of non-sinterable metal particles.

The sinterable metal particles having a particle size of 100 nm or less and the non-sinterable metal particles having a particle size of greater than 100 nm may be the same as each other or may be different from each other. For example, the sinterable metal particles having a particle size of 100 nm or less may be silver particles, while the non-sinterable metal particles having a particle size of greater than 100 nm may be silver or silver oxide particles. In another example, the sinterable metal particles having a particle size of 100 nm or less may be silver or silver oxide particles, while the non-sinterable metal particles having a particle size of greater than 100 nm may be copper or copper oxide particles.

In the film-shaped firing material of the present embodiment, a content of the sinterable metal particles relative to the total mass (100 mass%) of all of the metal particles may be from 10 to 100 mass%, or may be from 20 to 95 mass%.

The surface of the sinterable metal particles and/or the non-sinterable metal particles may be coated with an organic substance. Providing a coating of an organic substance improves miscibility with the binder component and can prevent the cohesion of particles, and thereby the particles can be uniformly dispersed.

When the sinterable metal particles and/or the non-sinterable metal particles are coated with an organic substance, the mass of the sinterable metal particles and the non-sinterable metal particles is a value including the coating.

<Binder component>

The binder component is a solid at room temperature; with the binder component blended, the firing material can be formed into a film shape, and pressure sensitive adhesiveness can be imparted to the before-firing film-shaped firing material. The binder component may be a thermally decomposable binder component that is thermally decomposed when subjected to a heating treatment in the firing of the film-shaped firing material.

In the present specification, the term "room temperature" means 25°C.

In the present specification, the term "liquid" means a state in which viscosity can be measured using a B-type viscometer at room temperature. In the present specification, the term "solid" means a state in which viscosity cannot be measured using a B-type viscometer at room temperature.

The binder component is not limited as long as the effect of the present invention can be obtained; examples of a suitable binder component include a resin. Examples of the resin include an acrylic resin, a polycarbonate resin, a polylactic acid, and a polymer of a cellulose derivative, of which an acrylic resin is preferable. The acrylic resin includes a homopolymer of a (meth)acrylate compound, a copolymer of two or more types of (meth)acrylate compounds, and a copolymer of a (meth)acrylate compound and another copolymerizable monomer.

With respect to the resin constituting the binder component, the content of constituent units derived from a (meth)acrylate compound is, relative to the total mass (100 mass%) of the constituent units, preferably from 50 to 100 mass%, more preferably from 80 to 100 mass%, and even more preferably from 90 to 100 mass%.

In this context, "derived from" means that the monomer has undergone a change in the structure necessary for polymerization.

Specific examples of the (meth)acrylate compound include: an alkyl (meth)acrylate, such as methyl (meth)acrylate, ethyl (meth)acrylate, propyl (meth)acrylate, isopropyl (meth)acrylate, butyl (meth)acrylate, isobutyl (meth)acrylate, t-butyl (meth)acrylate, pentyl (meth)acrylate, amyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, and isostearyl (meth)acrylate;

a hydroxyalkyl (meth)acrylate, such as hydroxyethyl (meth)acrylate, 2-hydroxypropyl (meth)acrylate, 4-hydroxybutyl (meth)acrylate, 3-hydroxypropyl (meth)acrylate, 2-hydroxybutyl (meth)acrylate, and 3-hydroxybutyl (meth)acrylate;
a phenoxyalkyl (meth)acrylate, such as phenoxyethyl (meth)acrylate, and 2-hydroxy-3-phenoxypropyl (meth)acrylate;
an alkoxyalkyl (meth)acrylate, such as 2-methoxyethyl (meth)acrylate, 2-ethoxyethyl (meth)acrylate, 2-propoxyethyl (meth)acrylate, 2-butoxyethyl (meth)acrylate, and 2-methoxybutyl (meth)acrylate;
a polyalkylene glycol (meth)acrylate, such as polyethylene glycol mono(meth)acrylate, ethoxydiethylene glycol (meth)acrylate, methoxypolyethylene glycol (meth)acrylate, phenoxy polyethylene glycol (meth)acrylate, nonylphenoxy polyethylene glycol (meth)acrylate, polypropylene glycol mono(meth)acrylate, methoxypolypropylene glycol (meth)acrylate, ethoxypolypropylene glycol (meth)acrylate, and nonylphenoxy polypropylene glycol (meth)acrylate;
a cycloalkyl (meth)acrylate, such as cyclohexyl (meth)acrylate, 4-butylcyclohexyl (meth)acrylate, dicyclopentanyl (meth)acrylate, dicyclopentenyl (meth)acrylate, dicyclopentadienyl (meth)acrylate, bornyl (meth)acrylate, isobornyl (meth)acrylate, and tricyclodecanyl (meth)acrylate;
as well as benzyl (meth)acrylate and tetrahydrofurfuryl (meth)acrylate. An alkyl (meth)acrylate or an alkoxyalkyl (meth)acrylate are preferable, and the (meth)acrylate compound is more preferably butyl (meth)acrylate, ethylhexyl (meth)acrylate, lauryl (meth)acrylate, isodecyl (meth)acrylate, 2-ethylhexyl (meth)acrylate, and 2-ethoxyethyl (meth)acrylate, even more preferably 2-ethylhexyl (meth)acrylate, and particularly preferably 2-ethylhexyl methacrylate.

Herein, "(meth)acrylate" is a concept that encompasses both "acrylate" and "methacrylate".

The acrylic resin is preferably an acrylic resin having a constitutional unit derived from a methacrylate. When the binder component contains a constituent unit derived from methacrylate, firing can be performed at a relatively low temperature, and conditions for obtaining sufficient adhesion strength after sintering can be easily satisfied.

The other copolymerizable monomer is not particularly limited as long as it is a compound that can be copolymerized with the (meth)acrylate compound, and examples include unsaturated carboxylic acids such as (meth)acrylic acid, vinyl benzoate, maleic acid, and vinyl phthalate; and vinyl group-containing radical polymerizable compounds such as vinyl benzyl methyl ether, vinyl glycidyl ether, styrene, $\alpha$-methylstyrene, butadiene, and isoprene.

A mass average molecular weight (Mw) of the resin constituting the binder component is preferably from 10000 to 1000000, and more preferably from 10000 to 800000. When the mass average molecular weight of the resin is within the range described above, sufficient film strength is expressed as a film, and flexibility is easily imparted.

Note that in the present specification, unless otherwise specified, "mass average molecular weight" refers to a polystyrene equivalent value measured by gel permeation chromatography (GPC).

A glass transition temperature (Tg) of the resin constituting the binder component can be determined by calculation using the Fox equation presented below, and the Tg of the resin is preferably from -60°C to 50°C, more preferably from -30°C to 10°C, and even more preferably from -20°C to below 0°C. When the Tg of the resin determined from the Fox equation is less than or equal to the upper limit described above, the pressure sensitive adhesive force before firing between the film-shaped firing material and an adherend (for example, a chip, a substrate, or the like) is improved. In addition, the flexibility of the film-shaped firing material is increased. Meanwhile, when the Tg of the resin determined from the Fox equation is greater than or equal to the lower limit described above, the film shape can be maintained, and the film-shaped firing material can be more easily peeled apart from the support sheet or the like.

$$1/Tg = (W1/Tg1) + (W2/Tg2) + ... + (Wm/Tgm)$$

(where Tg is the glass transition temperature of the resin constituting the binder component, Tg1, Tg2,... and Tgm are the glass transition temperatures of the homopolymers of each monomer serving as the raw materials of the resin constituting the binder component, and W1, W2,... and Wm are the mass fractions of each monomer. Of course, W1 + W2 +...+ Wm = 1.)

As the glass transition temperatures of the homopolymers of each monomer in the Fox equation, the glass transition temperature values described in the Polymer Data Handbook or in the Handbook of Pressure Sensitive Adhesive Technology can be used.

The binder component may be a thermally decomposable binder component that is thermally decomposed when subjected to a heating treatment in the firing of the film-shaped firing material. Thermal decomposition of the binder component can be confirmed by the mass loss of the binder component due to firing. Note that the component blended as a binder component may be nearly thermally decomposed by firing, but the total mass of the component blended as the binder component may also not be thermally decomposed by firing.

After being fired at the firing temperature described in a later section, the binder component may have a mass of 10 mass% or less, 5 mass% or less, or 3 mass% or less, with respect to the total mass (100 mass%) of the binder component prior to firing.

<Liquid component>

The film-shaped firing material according to the present embodiment contains a liquid component that is a liquid at room temperature and has a boiling point of from 300 to 450°C. By containing the liquid component, the film-shaped firing material according to the present embodiment has a sufficient adhesive force with a support sheet and an excellent dicing suitability; meanwhile, the exuding of the film-shaped firing material from between a semiconductor chip and a substrate when the semiconductor chip and the substrate are subjected to sinter bonding is suppressed.

A boiling point of the liquid component is from 300 to 450°C, preferably from 310 to 430°C, and more preferably from 320 to 420°C. When the boiling point is greater than or equal to the lower limit of the range described above, even during the step of drying a solvent in a firing material composition in a method for producing the film-shaped firing material described in a later section, the liquid component is hard to volatilize and becomes contained in the film-shaped firing material; as a result, the adhesive force between the film-shaped firing material and a support sheet is sufficient, and an excellent dicing suitability can be achieved. When the boiling point is less than or equal to the upper limit of the range described above, the liquid component is evaporated or pyrolyzed in the step of firing the film-shaped firing material described in a later section.

In the present specification, the term "boiling point' means the boiling point at atmospheric pressure (101,325 Pa) .

Further, in the present specification, the term "solvent" means a substance that is in a liquid state at room temperature and has a boiling point of lower than 300°C.

A vapor pressure of the liquid component at a drying temperature during the step of drying a solvent in a firing material composition in accordance with the method for producing the film-shaped firing material described in a later section is preferably 100 Pa or less, more preferably 10 Pa or less, and even more preferably 1.0 Pa or less. When the vapor pressure is less than or equal to the upper limit described above, even during the step of drying a solvent in a firing material composition in the method for producing the film-shaped firing material described in a later section, the liquid component is hard to volatilize and becomes contained in the film-shaped firing material; as a result, the adhesive force between the film-shaped firing material and a support sheet is sufficient, and an excellent dicing suitability can be achieved.

A lower limit of the vapor pressure, although not limited as long as the effect of the present invention can be achieved, may be, for example, 0.01 Pa or greater, 0.02 Pa or greater, or 0.03 Pa or greater. The aforementioned vapor pressure is preferably, for example, from 0.01 Pa to 100 Pa, more preferably from 0.02 Pa to 10 Pa, and even more preferably from 0.03 Pa to 1.0 Pa.

A content ratio of the liquid component with respect to the total mass of the film-shaped firing material is preferably from 0.1 to 3.0 mass%, more preferably from 0.2 to 2.5 mass%, even more preferably from 0.3 to 2.0 mass%, further preferably from 0.4 to 1.5 mass%, and particularly preferably from 0.5 to 1.0 mass%. When the content ratio of the liquid component is greater than or equal to the lower limit of the range described above, the adhesive force between the film-shaped firing material and a support sheet is sufficient, and an excellent dicing suitability can be achieved.

When the content ratio of the liquid component is less than or equal to the upper limit of the range described above, exuding of the film-shaped firing material from between a semiconductor chip and a substrate when the semiconductor chip and the substrate are subjected to sinter bonding is suppressed.

The content ratio of the liquid component in the film-shaped firing material can be obtained by analyzing, by IR, gas chromatography, or the like, the components obtained by removing the sinterable metal particles and the non-sinterable metal particles. The removal of the sinterable metal particles and the non-sinterable metal particles from the film-shaped firing material can be performed, for example, by the following method.

The before-firing film-shaped firing material is mixed with approximately 10 times the amount by weight of an organic solvent; then, the mixture is left to stand for approximately 30 minutes until the sinterable metal particles and the non-sinterable metal particles settle. The supernatant is extracted with a syringe and dried for 10 minutes at 120°C; then, the residue is recovered. In this way, it is possible to separate components excluding the sinterable metal particles and the non-sinterable metal particles from the film-shaped firing material. The organic solvent is not limited as long as the organic solvent is one that can dissolve the binder component and the liquid component, and examples thereof include ethyl acetate, methyl ethyl ketone (MEK), and toluene.

The liquid component may be a monomer or a multimer as long as the liquid component has a boiling point of from 300 to 450°C and is a liquid at room temperature. Examples of the monomer include bis(2-ethylhexyl) adipate (boiling point: 335°C), bis(2-ethylhexyl) phthalate (boiling point: 361°C), tris(2-ethylhexyl) trimellitate (boiling point: 414°C), dibutyl phthalate (boiling point: 340°C), and tri-o-cresyl phosphate (boiling point: 410°C). These may be used alone or may be combined and used.

In addition to the sinterable metal particles, the non-sinterable metal particles, the binder component, and the liquid component described above, the film-shaped firing material according to the present embodiment may contain another additive, which does not correspond to the sinterable metal particles, the non-sinterable metal particles, the binder component, or the liquid component, within a range that does not impair the effect of the present invention.

Examples of another additive that may be contained in the film-shaped firing material according to the present embodiment include a solvent, a dispersant, a tackifier, a storage stabilizer, an anti-foaming agent, a thermal decomposition accelerator, and an antioxidant. A single type of additive may be contained, or two or more types may be contained. These additives are not particularly limited, and those that are normally used in this field can be selected as appropriate.

A content ratio of another additive to the total mass of the film-shaped firing material is preferably 2 mass% or less, more preferably 1 mass% or less.

A film-shaped firing material with a support sheet according to the present embodiment described in a later section includes a film-shaped firing material and a support sheet provided on at least one side (surface) of the film-shaped firing material; an adhesive force (a2) of the film-shaped firing material to the support sheet is smaller than an adhesive force (a1) of the film-shaped firing material to a semiconductor wafer, the adhesive force (a1) being preferably 0.1 N/25 mm and greater while the adhesive force (a2) being preferably from 0.1 N/25 mm to 0.5 N/25 mm.

An adhesive force of the film-shaped firing material according to the present embodiment to a wafer, which can be obtained by a method described in "Measurement of adhesive force (a1)" below, is preferably 0.1 N/25 mm or greater, more preferably 0.5 N/25 mm or greater, and even more preferably 1.0 N/25 mm or greater. When the adhesive force (a1) is greater than or equal to the lower limit described above, an excellent dicing suitability can be achieved. In addition, when a chip and a substrate are transported while being temporarily fixed with the before-firing film-shaped firing material, shifting of the position of the chip can be suppressed.

An adhesive force of the film-shaped firing material according to the present embodiment to a support sheet, which can be obtained by a method described in "Measurement of adhesive force (a2)" below, is preferably from 0.1 N/25 mm to 0.5 N/25 mm, more preferably from 0.2 N/25 mm to 0.5 N/25 mm, and even more preferably from 0.2 N/25 mm to 0.4 N/25 mm. When the adhesive force (a2) to a support sheet is greater than or equal to the lower limit of the range, an excellent dicing suitability can be achieved.

When the adhesive force (a2) is smaller than the adhesive force (a1) and less than or equal to the upper limit described above, the film-shaped firing material can be easily peeled off from the support sheet when chips, individual pieces divided from a wafer via dicing, are being picked up, and chips with diced film-shaped firing material can be easily picked up.

<Composition>

The film-shaped firing material according to the present embodiment may be composed of sinterable metal particles, a binder component, a liquid component, and another additive, and the sum of contents (mass%) of these may be 100 mass%.

When the film-shaped firing material according to the present embodiment contains non-sinterable metal particles, the film-shaped firing material may be composed of sinterable metal particles, non-sinterable metal particles, a binder component, a liquid component, and another additive, and the sum of contents (mass%) of these may be 100 mass%.

In the film-shaped firing material, a content of the sinterable metal particles with respect to the total mass (100 mass%) of all components except the component that is a liquid at room temperature (hereinafter, referred to as "solids content") is preferably from 15 to 98 mass%, more preferably from 15 to 95 mass%, and even more preferably from 20 to 90 mass%. When the content of the sinterable metal particles is less than or equal to the upper limit described above, a sufficient content of the binder component can be ensured, and therefore the shape of the film can be maintained. On the other hand, when the content of the sinterable metal particles is greater than or equal to the lower limit described above, the sinterable metal particles themselves or the sinterable metal particles and the non-sinterable metal particles are fused together during firing, and a high bonding adhesive strength (shear adhesive force) is exhibited after firing.

When the film-shaped firing material contains non-sinterable metal particles, a total content of the sinterable metal particles and the non-sinterable metal particles with respect to the total mass (100 mass%) of the solids content in the film-shaped firing material is preferably from 50 to 98 mass%, more preferably from 70 to 97 mass%, and even more preferably from 80 to 95 mass%.

A content of the binder component with respect to the total mass (100 mass%) of the solids content in the film-shaped firing material is preferably from 2 to 50 mass%, more preferably from 3 to 30 mass%, and even more preferably from 5 to 20 mass%. When the content of the binder component is less than or equal to the upper limit described above, a sufficient content of the sinterable metal particles can be ensured, and therefore the bonding adhesive force between the film-shaped firing material and an adherend is improved. On the other hand, when the content of the binder component is greater than or equal to the lower limit described above, the shape of the film can be maintained.

In the film-shaped firing material, a mass ratio of the sinterable metal particles with respect to the binder component (sinterable metal particles: binder component) is preferably from 50:1 to 1:1, more preferably from 35:1 to 2.5:1, and even more preferably from 20:1 to 4:1. When the film-shaped firing material contains non-sinterable metal particles, a mass ratio of the sinterable metal particles and the non-sinterable metal particles with respect to the binder component [(sinterable metal particles + non-sinterable metal particles):(binder component)] is preferably from 50:1 to 1:10, more preferably from 35:1 to 1:4, and even more preferably from 20:1 to 1:2.5.

In the film-shaped firing material, a content of the liquid component with respect to 100 parts by mass of the sinterable metal particles is preferably from 0.1 to 30 parts by mass, more preferably from 0.2 to 25 parts by mass, and even more preferably from 0.3 to 20 parts by mass.

In the film-shaped firing material, a content of the liquid component with respect to 100 parts by mass of the binder component is preferably from 0.1 to 150 parts by mass, more preferably from 0.4 to 125 parts by mass, and even more preferably from 0.6 to 100 parts by mass.

In the film-shaped firing material, a content ratio of a solvent, including one with a relatively high boiling point included in the firing material composition described in a later section, with respect to the total mass of the film-shaped firing material is preferably 1% or less.

In the film-shaped firing material, a content of the liquid component with respect to a total of 100 parts by mass of the sinterable metal particles and the binder component is preferably from 0.1 to 25 parts by mass, more preferably from 0.1 to 20 parts by mass, and even more preferably from 0.1 to 15 parts by mass.

The film-shaped firing material according to the present embodiment described above has a shape of a film, and thus the thickness is even. In addition, the film-shaped firing material according to the present embodiment contains a liquid component that is a liquid at room temperature and has a boiling point of from 300 to 450°C. As such, the film-shaped firing material according to the present embodiment has a sufficient adhesive force with a support sheet and an excellent dicing suitability; meanwhile, the exuding of the film-shaped firing material from between a semiconductor chip and a substrate when the chip and the substrate are subjected to sinter bonding is suppressed.

The film-shaped firing material can be a film-shaped firing material with a support sheet in which the support sheet is provided on at least one side (surface) of the film-shaped firing material.

Details of the film-shaped firing material with a support sheet are described in a later section.

## <<Method for producing film-shaped firing material>>

The film-shaped firing material can be formed using a firing material composition containing the constituent material.

For example, a film-shaped firing material can be formed at a targeted location by applying or printing a firing material composition containing a solvent and each component for constituting the film-shaped firing material onto a surface on which the film-shaped firing material is to be formed, and then volatilizing the solvent as necessary.

An example of the surface on which the film-shaped firing material is to be formed is a surface of a release film.

When the firing material composition is applied by coating, the solvent is preferably one having a boiling point of lower than 200°C, and examples of such solvents include n-hexane (boiling point: 68°C), ethyl acetate (boiling point: 77°C), 2-butanone (boiling point: 80°C), n-heptane (boiling point: 98°C); methylcyclohexane (boiling point: 101°C), toluene (boiling point: 111°C), acetyl acetone (boiling point: 138°C), n-xylene (boiling point: 139°C), and dimethylformamide (boiling point: 153°C). These may be used alone or may be combined and used.

The firing material composition may be applied by a well-known method including, for example, methods using various coaters such as an air knife coater, a blade coater, a bar coater, a gravure coater, a comma coater (trade name), a roll coater, a roll knife coater, a curtain coater, a die coater, a knife coater, a screen coater, a Mayer bar coater, and a kiss coater.

In a case in which the firing material composition is printed, the solvent can be any as long as it is one that can be volatilized and dried after printing, and a boiling point of the solvent is preferably from 65 to 280°C. Examples of such a solvent having a relatively high boiling point include a solvent having a boiling point of less than 200°C as exemplified above, isophorone (boiling point: 215°C), butyl carbitol (boiling point: 230°C), 1-decanol (boiling point: 233°C), and butyl carbitol acetate (boiling point: 247°C).

When the boiling point exceeds 280°C, the solvent is less likely to volatilize in the volatilization and drying after printing; as a result, it may be difficult to ensure a desired shape, or the solvent may remain in the film during firing, which may degrade bonding adhesiveness. When the boiling point is lower than 65°C, the solvent is volatilized during printing, and the stability of the thickness may be impaired. When a solvent with a boiling point of from 200 to 280°C is used, an increase in viscosity caused by volatilization of the solvent during printing can be suppressed, and printing suitability can be obtained.

The firing material composition can be printed by a well-known printing method, and examples include methods such as letterpress printing such as flexographic printing, intaglio printing such as gravure printing, lithography printing such as offset printing, screen printing such as silk screen printing or rotary screen printing, and printing using various types of printers such as an inkjet printer.

When the firing material composition contains a solvent, a content ratio of the solvent with respect to the total mass of the firing material composition is preferably from 5 to 60 mass%, more preferably from 10 to 50 mass%, and even more preferably from 15 to 40 mass%. When the content ratio of the solvent is within the range described above, an excellent coatability can be obtained.

The shape of the film-shaped firing material may be set, as appropriate, in accordance with the shape of the object to be sintered and bonded, and a circular or rectangular shape is preferable. A circular shape is a shape corresponding to the shape of the semiconductor wafer. A rectangular shape is a shape corresponding to the shape of the chip. A corresponding shape refers to a shape that is the same as or substantially the same as the shape of the object to be subjected to sinter bonding.

When the film-shaped firing material is circular, the area of the circle may be from 3.5 to 1600 $cm^2$, and may be from 85 to 1400 $cm^2$. When the film-shaped firing material is rectangular, the area of the rectangle may be from 0.01 to 25 $cm^2$, or may be from 0.25 to 9 $cm^2$.

In particular, when the firing material composition is printed, a film-shaped firing material having a desired shape is easily formed.

Although drying conditions of the firing material composition are not limited, when the firing material composition contains a solvent, the composition is preferably dried by heating; in this case, for example, drying is preferably performed at a temperature from 70 to 250°C, or for example, from 80 to 180°C, for from 10 seconds to 10 minutes. The film-shaped firing material according to the present embodiment contains a liquid component that is a liquid at room temperature and has a boiling point of from 300 to 450°C. As such, even during the step of drying the solvent in the firing material composition, the liquid component is difficult to volatilize and becomes contained in the film-shaped firing material; as a result, the adhesive force between the film-shaped firing material and a support sheet is sufficient, and an excellent dicing suitability can be achieved.

<<Film-shaped firing material with a support sheet >>

The film-shaped firing material with a support sheet according to the present embodiment includes the film-shaped firing material described above and the support sheet provided on at least one side (surface) of the film-shaped firing material. The support sheet is one in which a pressure sensitive adhesive layer is provided on the entire surface or the outer circumferential section of a base material film, and the film-shaped firing material is preferably provided on the pressure sensitive adhesive layer. The film-shaped firing material may be provided in direct contact with the pressure sensitive adhesive layer, or may be provided in direct contact with the base material film. By adopting this configuration, the film-shaped firing material with a support sheet can be used as a dicing sheet that is used when dividing a semiconductor wafer into individual chips. Furthermore, this configuration allows the film-shaped firing material to be processed into the same shape as a chip when the film-shaped firing material is divided into individual pieces together with a semiconductor wafer with the use of a blade or the like, and thereby a semiconductor chip with film-shaped firing material can be produced.

An embodiment of the film-shaped firing material with a support sheet is described below. Fig. 2 and Fig. 3 are schematic cross-sectional views of the film-shaped firing material with a support sheet according to the present embodiment. As illustrated in Fig. 2 and Fig. 3, in 100a and 100b, which are the film-shaped firing materials with a support sheet according to the present embodiment, a film-shaped firing material 1 is temporarily attached, in a releasable manner, to an inner circumferential section of a support sheet 2 having a pressure sensitive adhesion portion on an outer circumferential section. As illustrated in Fig. 2, the support sheet 2 has a configuration in which the support sheet 2 is a pressure sensitive adhesive sheet having a pressure sensitive adhesive layer 4 and a base material film 3, the pressure sensitive adhesive layer 4 being on the upper surface of the base material film 3, wherein the surface of the inner circumferential section of the pressure sensitive adhesive layer 4 is covered by the film-shaped firing material while the pressure sensitive adhesion portion is exposed at the outer circumferential section of the pressure sensitive adhesive layer 4. Further, as illustrated in Fig. 3, the support sheet 2 may also have a configuration in which the support sheet 2 is a pressure sensitive adhesive sheet having a ring-shaped pressure sensitive adhesive layer 4 and a base material film 3, the ring-shaped pressure sensitive adhesive layer 4 being on the outer circumferential section of the base material film 3, wherein the surface of the inner circumferential section of the base material film 3 is covered by the film-shaped firing material.

The film-shaped firing material 1 is formed into a shape that is substantially the same as the shape of a workpiece (a semiconductor wafer or the like) to be affixed to the inner circumferential section of the support sheet 2. The support sheet 2 has the pressure sensitive adhesion portion on the outer circumferential section thereof. In a preferred aspect, the film-shaped firing material 1 having a diameter smaller than that of the support sheet 2 is concentrically laminated on the round support sheet 2. As illustrated, the pressure sensitive adhesion portion of the outer circumferential section is used to fix a ring frame 5.

(Base material film)

The base material film 3 is not particularly limited, and examples thereof include low-density polyethylene (LDPE), linear low density polyethylene (LLDPE), an ethylene-propylene copolymer, polypropylene, polybutene, polybutadiene, polymethylpentene, an ethylene-vinyl acetate copolymer, an ethylene-(meth)acrylic acid copolymer, an ethylene-methyl (meth)acrylate copolymer, an ethylene-ethyl (meth)acrylate copolymer, polyvinyl chloride, a vinyl chloride-vinyl acetate copolymer, a polyurethane film, and a film made from an ionomer. Note that "(meth)acrylic" is used herein in a sense that includes both acrylic and methacrylic.

Furthermore, for a case in which higher heat resistance is required for the support sheet, examples of the base material film 3 include polyester films such as polyethylene terephthalate, polybutylene terephthalate, and polyethylene naphthalate; and polyolefin films such as polypropylene, and polymethylpentene. Moreover, crosslinked films of these and films obtained by modifying these through radiation and discharging, etc. can also be used. The base material film may be a laminate of the above-mentioned films.

These films may be also used by laminating or combining two or more types. In addition, these films may be colored, printed, or the like, and used. Moreover, the film may be formed into a sheet by extrusion molding a thermoplastic resin, may be a stretched film, and may be formed into a sheet by forming a curable resin into a thin film through a predetermined means, and then curing the thin film.

The thickness of the base material film is not particularly limited and is preferably from 30 to 300 $\mu$m, and more preferably from 50 to 200 $\mu$m. When the thickness of the base material film is set to within the range described above, tearing of the base material film is unlikely to occur even when cutting is implemented through dicing. Furthermore, sufficient flexibility is imparted to the film-shaped firing material with a support sheet, and therefore good affixing properties are exhibited with respect to a workpiece (for example, a semiconductor wafer or the like).

The base material film can also be obtained by coating a surface with a release agent and implementing a release treatment. Examples of the release agent used in the release treatment include alkyd-based release agents, silicone-based release agents, fluorine-based release agents, unsaturated polyester-based release agents, polyolefinbased release agents, and wax-based release agents. Alkyd-based release agents, silicone-based release agents, and fluorine-based release agents exhibit heat resistance and thus are preferable.

In order to subject the surface of the base material film to a release treatment using the release agent described above, a gravure coater, a Mayer bar coater, an air knife coater, a roll coater, or the like is used to coat the surface with the release agent as is without a solvent or diluted with a solvent or in the form of an emulsion, and the base material film coated with the release agent is then supplied at ordinary temperature or under heating, or is cured by an electron beam, or a laminate may be formed by wet lamination, dry lamination, hot-melt lamination, melt-extrusion lamination, coextrusion, or the like.

(Pressure sensitive adhesive layer)

The support sheet 2 has a pressure sensitive adhesion portion on at least the outer circumferential section thereof. The pressure sensitive adhesion portion has a function of temporarily fixing the ring frame 5 to the outer circumferential section of the film-shaped firing materials with a support sheet 100a and 100b, and the ring frame 5 preferably can be released after the required steps. Therefore, a pressure sensitive adhesive with weak adhesiveness may be used in the pressure sensitive adhesive layer 4, or an energy ray-curable pressure sensitive adhesive in which adhesive force is reduced by energy ray irradiation may be used. A re-releasable pressure sensitive adhesive layer can be formed from a variety of commonly known pressure sensitive adhesives (for example, a general purpose pressure sensitive adhesive such as a rubber adhesive, an acrylic adhesive, a silicone adhesive, a urethane adhesive, and a vinyl ether adhesive; a pressure sensitive adhesive with surface irregularities; an energy ray-curable pressure sensitive adhesive, and a pressure sensitive adhesive containing a thermally expanding component).

As illustrated in Fig. 2, the support sheet 2 may have such a configuration: the support sheet 2 is a pressure sensitive adhesive sheet having a common configuration in which the pressure sensitive adhesive layer 4 is provided on the entire upper surface of the base material film 3, wherein the surface of the inner circumferential section of the pressure sensitive adhesive layer 4 is covered by the film-shaped firing material while the pressure sensitive adhesion portion is exposed at the outer circumferential section of the pressure sensitive adhesive layer 4. In this case, the outer circumferential section of the pressure sensitive adhesive layer 4 is used to fix the ring frame 5 described above, and the film-shaped firing material is laminated in a releasable manner on the inner circumferential section. As described above, a weak pressure sensitive adhesive may be used as the pressure sensitive adhesive layer 4, or an energy ray-curable pressure sensitive adhesive may be used.

In addition, in the configuration illustrated in Fig. 3, the ring-shaped pressure sensitive adhesive layer 4 is formed on the outer circumferential section of the base material film 3, serving as the pressure sensitive adhesion portion. In this case, the pressure sensitive adhesive layer 4 may be a single-layer pressure sensitive adhesive layer composed of the pressure sensitive adhesive described above, or a double-sided pressure sensitive adhesive tape, which includes a pressure sensitive adhesive layer composed of the pressure sensitive adhesive described above, that has been cut into an annular shape.

An acrylic adhesive or a silicone adhesive is preferably used as the weak pressure sensitive adhesive. Further, in view of the releasability of the film-shaped firing material, an adhesive force of the pressure sensitive adhesive layer 4 to a SUS board at 23°C is preferably from 30 to 120 mN/25 mm, more preferably from 50 to 100 mN/25 mm, and even more preferably from 60 to 90 mN/25 mm. When the adhesive force is too weak, the ring frame may fall off. When the adhesive force is too strong, releasing from the ring frame becomes difficult, and reuse of the ring frame also becomes difficult. In other words, when the adhesive force is greater than or equal to the lower limit of the range, it is possible to suppress the falling off of the ring frame. When the adhesive force is less than or equal to the upper limit of the range, releasing from the ring frame becomes easy, and reuse of the ring frame also becomes easy.

In a case in which an energy ray-curable re-releasable pressure sensitive adhesive layer is used in the support sheet having the configuration illustrated in Fig. 2, pressure sensitive adhesiveness may be reduced by irradiating in advance with energy rays a region at which the film-shaped firing material is laminated. At this time, the other regions are not irradiated with energy rays, and the pressure sensitive adhesive force may be maintained at a high level for the purpose of adhering to the ring frame 5, for example. To configure such that only the other regions are not irradiated with energy rays, an energy ray-shielding layer may be provided, for example, by printing in regions corresponding to the other regions of the base material film, and then irradiating the energy ray-shielding layer with energy rays from the base material film side. Furthermore, with the support sheet having the configuration illustrated in Fig. 2, in order to strengthen the adherence between the base material film 3 and the pressure sensitive adhesive layer 4, the surface of the base material film 3 on which the pressure sensitive adhesive layer 4 is provided may be subjected, as desired, to an unevenness-forming treatment through sandblasting, a solvent treatment, or the like, or may be subjected to a treatment such as a corona discharge treatment, electron beam irradiation, a plasma treatment, an ozone/ultraviolet irradiation treatment, a flame treatment, a chromic acid treatment, a hot air treatment, or other such oxidizing treatment. The surface thereof may also be subjected to a primer treatment.

A thickness of the pressure sensitive adhesive layer 4, although not limited, is preferably from 1 to 100 μm, more preferably from 2 to 80 μm, and particularly preferably from 3 to 50 μm.

In the film-shaped firing material with a support sheet, the film-shaped firing material is temporarily attached, in a releasable manner, to the inner circumferential section of the support sheet having a pressure sensitive adhesion portion on the outer circumferential section. According to the configuration example illustrated in Fig. 2, in the film-shaped firing material with a support sheet 100a, the film-shaped firing material 1 is laminated, in a releasable manner, on the inner circumferential section of the support sheet 2 composed of the base material film 3 and the pressure sensitive adhesive layer 4, and the pressure sensitive adhesive layer 4 is exposed at the outer circumferential section of the support sheet 2. In this configurational example, the film-shaped firing material 1 having a smaller diameter than that of the support sheet 2 is preferably detachably and concentrically laminated on the pressure sensitive adhesive layer 4 of the support sheet 2.

The film-shaped firing material with the support sheet 100a having the above configuration is affixed to the ring frame 5 at the pressure sensitive adhesive layer 4 exposed at the outer circumferential section of the support sheet 2.

An annular double-sided tape or a pressure sensitive adhesive layer may be further provided separately on a glue margin (the pressure sensitive adhesive layer exposed at the outer circumferential section of the pressure sensitive adhesive sheet) with respect to the ring frame. The double-sided tape has a configuration of pressure sensitive adhesive layer/core material/pressure sensitive adhesive layer; the pressure sensitive adhesive layer of the double-sided tape is not limited, and for example, a pressure sensitive adhesive such as a rubber adhesive, an acrylic adhesive, a silicone adhesive, or a polyvinyl ether adhesive may be used. The pressure sensitive adhesive layer is affixed to the ring frame at the outer circumferential section thereof when manufacturing a below described substrate with a chip. Examples of the core material of the double-sided tape include a polyester film, a polypropylene film, a polycarbonate film, a polyimide film, a fluororesin film, and a liquid crystal polymer film.

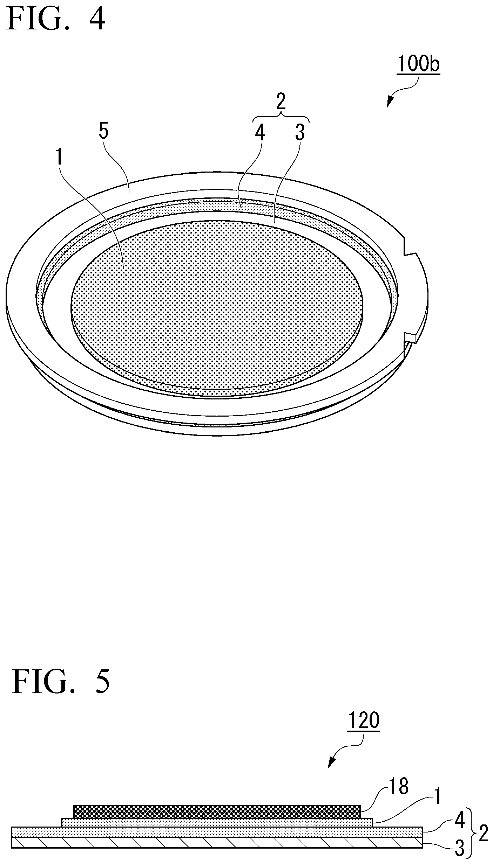

In the configuration example illustrated in Fig. 3, the ring-shaped pressure sensitive adhesive layer 4 is formed on the outer circumferential section of the base material film 3, serving as the pressure sensitive adhesion portion. Fig. 4 is a perspective view of the film-shaped firing material with a support sheet 100b illustrated in Fig. 3. In this case, the pressure sensitive adhesive layer 4 may be a single-layer pressure sensitive adhesive layer composed of the pressure sensitive adhesive described above, or a double-sided pressure sensitive adhesive tape, which includes a pressure sensitive adhesive layer composed of the pressure sensitive adhesive described above, that has been cut into an annular shape. The film-shaped firing material 1 is releasably laminated on the inner circumferential section of the base material film 3 that is surrounded by the pressure sensitive adhesion portion. In this configuration example, the film-shaped firing material 1 having a smaller diameter than that of the support sheet 2 is preferably releasably and concentrically laminated on the base material film 3 of the support sheet 2.

For the purpose of surface protection against contact with the outside, the film-shaped firing material with a support sheet may be provided with a release film on the surface of either the film-shaped firing material or the pressure sensitive adhesion portion or both until being used.

The surface protective film (release film) can be obtained by subjecting the surface of an above-exemplified base material film such as polyethylene, polyethylene terephthalate, polybutylene terephthalate, polyethylene naphthalate, and polypropylene to an above-described release treatment using a release agent. Examples of the release agent used in the release treatment include the release agents exemplified above in the description of the base material film.

A thickness of the film-shaped firing material with a support sheet is preferably from 1 to 500 μm, more preferably from 5 to 300 μm, and even more preferably from 10 to 150 μm.

<<Method for producing film-shaped firing material with a support sheet>>

The film-shaped firing material with a support sheet can be produced by sequentially laminating each of the layers described above in accordance with their corresponding positional relationship.

For example, when the pressure sensitive adhesive layer or the film-shaped firing material is being laminated on the base material film, a pressure sensitive adhesive composition or a firing material composition containing both a solvent and components constituting the pressure sensitive adhesive layer or the film-shaped firing material is applied or printed onto the release film and dried as necessary to volatilize the solvent, resulting in a shape of a film, and thereby the pressure sensitive adhesive layer or the film-shaped firing material is formed in advance on the release film; then, the exposed surface of the formed pressure sensitive adhesive layer or the film-shaped firing material which is on a side opposite to the side in contact with the release film is adhered to a surface of the base material film. In this case, the pressure sensitive adhesive composition or the firing material composition is preferably coated or printed on a release treatment surface of the release film. After formation of the laminated structure, the release film may be removed as necessary.

For example, in a case of producing the film-shaped firing material with a support sheet in which the pressure sensitive adhesive layer is laminated on the base material film while the film-shaped firing material is laminated on the pressure sensitive adhesive layer (a film-shaped firing material with a support sheet in which the support sheet is a laminate of a base material film and a pressure sensitive adhesive layer), the pressure sensitive adhesive layer is laminated onto the base material film by the above-described method, and separately, a firing material composition containing a solvent and components constituting the film-shaped firing material is coated or printed onto the release film and dried as necessary to volatilize the solvent, resulting in a shape of a film, and thereby the film-shaped firing material is formed on the release film; then, the exposed surface of this film-shaped firing material is adhered to the exposed surface of the pressure sensitive adhesive layer laminated on the base material, and thereby the film-shaped firing material is laminated on the pressure sensitive adhesive layer, resulting in a film-shaped firing material with a support sheet. In a case of forming a film-shaped firing material on a release film, the firing material composition is also preferably coated or printed onto a release treatment surface of the release film, and the release film may be removed as necessary after the laminated structure is formed.

In this manner, all of the layers other than the base material constituting the film-shaped firing material with a support sheet can be formed in advance on a release film and laminated by a method of adhering to the surface of the target layer, and therefore a layer in which this type of step is adopted may be appropriately selected as necessary to produce the film-shaped firing material with a support sheet.

Note that after all of the necessary layers have been provided, the film-shaped firing material with a support sheet may be stored in a state in which the release film is pasted to the surface of the outermost layer on the side opposite the support sheet.

«Laminate»

An embodiment of the present invention provides a laminate in which the film-shaped firing material with a support sheet and a wafer are affixed, wherein the support sheet, the film-shaped firing material, and the wafer are laminated in this order.

The laminate can be used as an intermediate in the below-described method for manufacturing a device.

Fig. 5 is a cross-sectional view schematically illustrating a laminate according to an embodiment of the present invention. In a laminate 120, a film-shaped firing material with a support sheet 100 and a semiconductor wafer 18 are laminated, and a support sheet 2, a film-shaped firing material 1, and the semiconductor wafer 18 are laminated in this order. The semiconductor wafer 18 may be provided in direct contact with the film-shaped firing material 1.

The semiconductor wafer may be a silicon wafer and a silicon carbide wafer, or may be a compound semiconductor wafer such as gallium arsenide. A circuit may be formed on the surface of the semiconductor wafer. The circuit can be formed on the wafer surface by a variety of methods including conventional commonly-used methods such as etching and lift-off. The opposite surface (back surface) of the circuit surface of the semiconductor wafer may be ground by a known means using a grinder or the like. When the back surface is to be ground, a pressure sensitive adhesive sheet called a front surface protective sheet can be affixed to the circuit surface to protect the circuit on the front surface. Grounding of the back surface can be performed by fixing the circuit surface side (i.e., the front surface protective sheet side) of the wafer using a chuck table or the like and grounding the back surface side on which no circuit is formed using a grinder. The thickness of the wafer after grinding is not particularly limited, but is normally approximately 20 to 500 $\mu$m. Next, as necessary, a crushed layer generated during the back surface grinding is removed.

The crushed layer can be removed by chemical etching, plasma etching, or the like. After grinding, a metal film may be provided on the back surface, and the metal film may be a single film or a plurality of films. The metal film can be formed using various methods such as electrolytic or electroless plating, and sputtering.

The shape of the workpiece (wafer or the like) to be affixed is typically circular, and thus the shapes of the film-shaped firing material 1 and the support sheet 2 are also preferably circular.

In the laminate 120, the diameter of the film-shaped firing material 1 is preferably the same as the diameter of the semiconductor wafer 18 or greater than the diameter of the semiconductor wafer 18.

In the laminate 120, the diameter of the support sheet 2 is preferably larger than the diameter of the film-shaped firing material 1.

The laminate can be manufactured by laminating the film-shaped firing material with a support sheet and the wafer so as to have a corresponding positional relationship.

<<Method of manufacturing a device>>

Next, a case in which a semiconductor wafer is used as a wafer and the firing material is applied in the production of a semiconductor device is used as an example to describe a method of utilizing the film-shaped firing material with a support sheet according to the present embodiment.

A first embodiment of the method for producing a device according to the present invention includes:

dicing the semiconductor wafer and the film-shaped firing material of the aforementioned laminate (hereinafter, also referred to as step 1);

peeling the diced film-shaped firing material off from the support sheet to obtain a semiconductor chip with film-shaped firing material (hereinafter, also referred to as step 2);

affixing the semiconductor chip with film-shaped firing material to a surface of a substrate (hereinafter, also referred to as step 3); and

firing and pressurizing the film firing material of the semiconductor chip with film-shaped firing material to bond the semiconductor chip with film-shaped firing material to the substrate (hereinafter, also referred to as step 4).

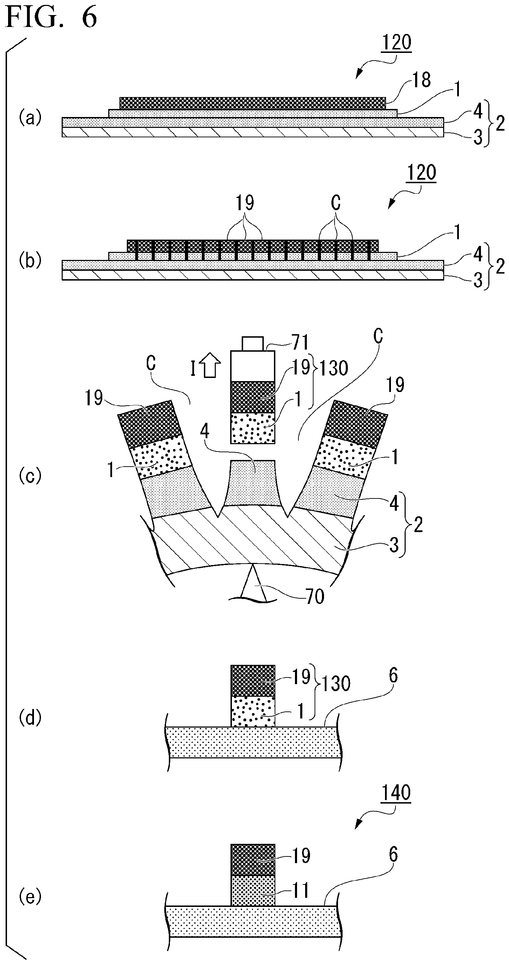

The aforementioned steps 1 to 4 of the method for producing a semiconductor device are described below with reference to Fig. 6.

■ Step 1

In step 1, the laminate 120 is used, the laminate 120 being obtained by, as illustrated in Fig. 6(a), affixing the film-shaped firing material 1 of the film-shaped firing material with the support sheet 100 to the semiconductor wafer 18, and laminating the support sheet 2, the film-shaped firing material 1, and the semiconductor wafer 18 in this order.

Next, as illustrated in Fig. 6(b), dicing of the semiconductor wafer is performed. The laminate of semiconductor wafer/film-shaped firing material/support sheet is diced for each circuit formed on the wafer surface, resulting in laminates of chip/film-shaped firing material/support sheet. The dicing is carried out by cutting the semiconductor wafer and the film-shaped firing material together. According to the film-shaped firing material with a support sheet of the present embodiment, adhesive force is exhibited between the film-shaped firing material and the support sheet during dicing; as such, it is possible to prevent chipping and scattering of the chips, and an excellent dicing suitability can be achieved. A method of dicing is not limited, and examples thereof include a method for dividing a semiconductor wafer into individual pieces by a known technique such as fixing the peripheral section of the support sheet (outer circumferential section of the support) with a ring frame and then using a rotating round blade such as a dicing blade during dicing of a semiconductor wafer. Regarding a cut depth into the support sheet created by the dicing, the film-shaped firing material may be completely cut, and the cut depth is preferably into from 0 to 30 $\mu$m from the interface between the film-shaped firing material and the support sheet. By reducing the amount cut into the support sheet, it is possible to suppress the melting of the pressure sensitive adhesive layer and the base material film constituting the support sheet as well as the generation of burrs due to friction from the dicing blade.

Note that when a semiconductor wafer having a circuit formed on a surface is diced into individual pieces (chips), the individual pieces are also referred to, in particular, as elements or semiconductor elements.

The film-shaped firing material with a support sheet according to the present embodiment contains a liquid component that is a liquid at room temperature and has a boiling point of from 300 to 450°C; as such, the adhesive force between the film-shaped firing material and the support sheet is sufficient during dicing, making it possible to prevent dicing defects such as chipping or scattering of the chips, achieving an excellent dicing suitability.

• Step 2

In step (2), the diced film-shaped firing material 1 and the support sheet 2 are peeled apart, resulting in a semiconductor chip with film-shaped firing material 130.

In step 2, for example, the support sheet may be expanded. When a film having excellent extensibility is selected as the base material film of the support sheet, the support sheet has excellent expandability. A diced semiconductor chip with film-shaped firing material is picked up by a general-purpose means such as a collet, and thus the film-shaped firing material and the support sheet are peeled apart. This results in a chip having film-shaped firing material on the back surface (semiconductor chip with film-shaped firing material).

As illustrated in Fig. 6(c), a force can be applied from the side of the base material film 3 towards the laminate 120 on which cuts C have been formed while a semiconductor chip 19 is being pulled away (picked up) together with the diced film-shaped firing material 1 from the pressure sensitive adhesive layer 4 of the support sheet, resulting in a semiconductor chip with film-shaped firing material 130.

Here, as one embodiment, a semiconductor chip with film-shaped firing material 130 having the chip 19 and the film-shaped firing material 1 can be produced.

Fig. 6(c) illustrates an example in which a protuberance (pin) 70 is projected from a raised portion (not illustrated) of a device for producing a semiconductor device, a tip end of the protuberance 70 pushes the laminate 120 upward from the side of the base material film 3, and thereby a force is applied in the projection direction of the protuberance 70 to the laminate 120 on which the cuts C and the semiconductor chip 19 have been formed. At this time, push-up conditions such as the projection amount (push-up amount) of the protuberance 70, the projection speed (push-up speed), and the holding time (push-up wait time) in the projected state can be adjusted as appropriate. The number of protuberances 70 is not particularly limited, and may be selected as appropriate.

Further, Fig. 6(c) illustrates an example in which the semiconductor chip 19 is pulled upward by a pull-up portion 71 of the device for producing a semiconductor device, and thereby the semiconductor chip 19 is peeled off, together with the film-shaped firing material 1, from the pressure sensitive adhesive layer 4. Here, the pull-up direction of the semiconductor chip 19 is indicated by an arrow I.

Note that in the picking up of the semiconductor chip 19, the method of raising the laminate 120 may be a well-known method, and examples include, in addition to a method of raising up using a protuberance like that describe above, a method of raising the laminate 120 by moving a slider along the laminate 120.

Note that the method of pulling up the semiconductor chip 19 may be a well-known method, and examples thereof include a method in which the front surface of the semiconductor chip 19 is suctioned and pulled up by a vacuum collet.

▪ Step 3

Next, in step 3, as illustrated in Fig. 6(d), the film-shaped firing material 1 of the semiconductor chip with film-shaped firing material 130 is affixed to a surface of a substrate 6. Through this, the chip 19 is affixed to the substrate 6 via the film-shaped firing material 1. The substrate 6 also includes a lead frame, a heat sink, or the like. According to the film-shaped firing material of the present embodiment, exertion of pressure sensitive adhesive force is also anticipated between the film-shaped firing material and the substrate. Thus, even in a state in which the chip and the substrate are temporarily fixed by the film-shaped firing material before firing, shifting of the chip position such as when being conveyed can be suppressed.

• Step 4

Next, in step 4, the film-shaped firing material is fired, sinter bonding the chip 19 and the substrate 6 (Fig. 6e). The exposed surface of the film-shaped firing material 1 of the semiconductor chip with film-shaped firing material 130 is affixed to the substrate 6, and the substrate 6 and the chip 19 can be subjected to sinter bonding with the film-shaped firing material 1 interposed therebetween. Through firing, the sinterable metal particles in the film-shaped firing material 1 are melted and bonded to form a sintered body 11, and the chip 19 and the substrate 6 are sintered and bonded to obtain a semiconductor device 140. The film-shaped firing material of the present embodiment contains a liquid component that is a liquid at room temperature and has a boiling point of from 300 to 450°C; as such, exuding of the film-shaped firing material from between the chip 19 and the substrate 6 when the chip 19 and the substrate 6 are subjected to sinter bonding is suppressed.

A heating temperature at which the film-shaped firing material is fired may be set as appropriate with consideration of details such as the type of the film-shaped firing material, but the heating temperature is preferably from 100 to 600°C, more preferably from 150 to 550°C, and even more preferably from 200 to 500°C. A heating time may be set as appropriate with consideration of details such as the type of the film-shaped firing material, but the heating time is preferably from 5 seconds to 180 minutes, more preferably from 5 seconds to 150 minutes, and even more preferably from 10 seconds to 120 minutes.

The film-shaped firing material may be fired through pressurized firing in which the film-shaped firing material is fired with pressure being applied. An example of a pressurizing condition is approximately from 0.1 to 50 MPa, preferably from 0.5 to 30 MPa, and more preferably from 1.0 to 20 MPa.

It is preferable that the film-shaped firing material is fired by first heating the film-shaped firing material till the aforementioned heating temperature is reached and then performing the aforementioned pressurization.

Note that in the embodiment described above, a case was exemplified in which the chip of the film-shaped firing material and the substrate thereof were sintered and bonded, but the target for sintering and bonding with the film-shaped firing material is not limited to the case exemplified above, and sintering and bonding can be implemented with various articles that are sintered in contact with the film-shaped firing material.

Further, a second embodiment of the method for producing a device according to the present invention includes affixing a semiconductor chip with film-shaped firing material, obtained by affixing a semiconductor chip to the film-shaped firing material described above, to a surface of a substrate, and firing and pressurizing the film firing material of the semiconductor chip with film-shaped firing material to bond the semiconductor chip with film-shaped firing material to the substrate.

In the first embodiment described above, the film-shaped firing material can be processed into the same shape as a chip by dividing a semiconductor wafer into individual pieces together with the film-shaped firing material with the use of a blade or the like, and thereby a semiconductor chip with film-shaped firing material can be produced. Meanwhile, in the second embodiment, a device can be produced by affixing a semiconductor chip with film-shaped firing material, obtained by attaching a semiconductor chip that is an individual piece to a film-shaped firing material, to a surface of a substrate, and firing and pressurizing the film firing material of the semiconductor chip with film-shaped firing material to bond the semiconductor chip with film-shaped firing material to the substrate.

The affixing of the semiconductor chip with film-shaped firing material to a surface of a substrate in the second embodiment can be performed under the conditions described in step 3 of the first embodiment. Further, the firing and pressurization of the film firing material of the semiconductor chip with film-shaped firing material in the second embodiment can be performed under the conditions described in step 4 of the first embodiment.

Note that in the embodiment described above, a case was exemplified in which the chip of the film-shaped firing material and the substrate thereof were sintered and bonded, but the target for sintering and bonding with the film-shaped firing material is not limited to the case exemplified above, and sintering and bonding can be implemented with various articles that are sintered in contact with the film-shaped firing material.

[Examples]

The present invention will be described in further detail below with reference to Examples and the like, but the scope of the present invention is not limited to these Examples and the like.

<<Examples 1 to 3 and Comparative Examples 1 and 2>>

<Manufacturing of a firing material composition>

The components used in the manufacturing of a firing material composition are shown below. Here, metal particles having a particle diameter of not greater than 100 nm are expressed as "sinterable metal particles".

Sinterable metal particle-containing paste material

▪ Alconano Silver Paste ANP-4 (organic coated composite silver nanopaste available from Nanoparticle Laboratory Corporation: alcohol derivative coated silver particles; metal content of 80 mass% or higher; 25 mass% or more of silver particles (sinterable metal particles) having an average particle diameter of 100 nm or less)

Binder component

▪ Acrylic polymer (2-ethylhexyl methacrylate polymer, mass average molecular weight: 260000, L-0818, available from the Nippon Synthetic Chemical Industry Co., Ltd., MEK diluted product, solids content 58.4 mass%, Tg: -10°C)

(Liquid component)

▪ Bis(2-ethylhexyl) adipate (boiling point: 335°C)

The components were mixed in accordance with the formulations presented in Table 1 below, resulting in firing material compositions for Examples 1 to 3 and Comparative Examples 1 and 2. The value of each component in Table 1 is represented in mass%. Note that the content ratios of the binder component and content ratios of metal particles in Table 1 indicate the content ratio as solids content.

<Manufacturing of the film-shaped firing material>

One side of a release film (thickness: 38 $\mu$m, SP-PET381031, available from Lintec Corporation) was coated with a firing material composition obtained as described above; then, drying was performed at 150°C for 10 minutes, resulting in a film-shaped firing material.

<Manufacturing of the film-shaped firing material with a support sheet >

The film-shaped firing material obtained above was cut, along with the release film, into a round shape having a diameter of 153 mm.

A dicing sheet (Adwill G-011, available from Lintec Corporation) was used as a support sheet in which a pressure sensitive adhesive layer having a thickness of 10 $\mu$m is laminated on a base material film having a thickness of 70 $\mu$m; the film-shaped firing material cut into a round shape was affixed to the surface of the pressure sensitive adhesive layer of the dicing sheet, resulting in a film-shaped firing material with a support sheet in which a round film-shaped firing material and a release film are laminated on a dicing sheet (support sheet) having a pressure sensitive adhesive layer on a base material film.

Measurement of adhesive force (a1)

A silicon wafer (available from Science & Technology Inst., Co., diameter: 150 mm, thickness: 500 μm) of which a surface was chemically mechanically polished until the arithmetic average roughness (Ra) became 0.02 μm was prepared as an adherend.

Next, after the surface protective film such as the release film was removed, the film-shaped firing material with a support sheet was adhered to the treated surface of the silicon wafer at 50°C. Next, the support sheet was peeled off from the film-shaped firing material, and a polyethylene terephthalate (PET) film having a thickness of 12 μm was stuck to the exposed film-shaped firing material and firmly adhered (lined). The laminate of PET film and film-shaped firing material was cut into a piece having a width of 25 mm or greater and a length of 100 mm or greater, resulting in a laminate in which the laminate composed of the film-shaped firing material and the PET film is affixed to the silicon wafer.

The resulting laminate was left in an atmosphere at 23°C and 50% relative humidity for 20 minutes; then, using a universal tensile testing machine (5581 testing machine, available from Instron), a 180° peel test was performed in accordance with JIS Z0237:2000. Specifically, the film-shaped firing material lined with PET film of each of the examples was peeled off together with the PET film from the silicon wafer at a peeling speed of 300 mm/min. In this case, the film-shaped firing material lined with PET film was peeled in the length direction such that the surface of the silicon wafer and the surface of the film-shaped firing material that were in contact with each other were at an angle of 180°. Then, the load (peeling force) at the time of this 180° peeling was measured, and the measured value was taken as the adhesive force (a1) [N/25 mm].

Measurement of adhesive force (a2)

The film-shaped firing material with a support sheet of each of the examples was left in an atmosphere at 23°C and 50% relative humidity for 20 minutes; then, using a universal tensile testing machine (5581 testing machine, available from Instron), a 180° peel test was performed in accordance with JIS Z0237:2000. Specifically, after the surface protective film such as the release film is removed from the film-shaped firing material with a support sheet of each of the examples, polyethylene terephthalate (PET) film having a thickness of 12 μm was adhered to the exposed film-shaped firing material. Next, the film-shaped firing material was peeled off together with the PET film from the support sheet at a peeling speed of 300 mm/min. In this case, the film-shaped firing material lined with PET film was peeled off in the length direction together with the PET film such that the surface of the support sheet and the surface of the film-shaped firing material that were in contact with each other were at an angle of 180°. Then, the load (peeling force) at the time of this 180° peeling was measured, and the measured value was taken as the adhesive force (a2) [N/25 mm]. The results are shown in Table 1.

Note that when a dicing sheet (Adwill G-011, available from Lintec Corporation) was used as the support sheet, the pressure sensitive adhesive layer of the dicing sheet and the film-shaped firing material were adhered so as to be in contact with each other, resulting in a film-shaped firing material with a support sheet.

<Evaluation of dicing suitability of film-shaped firing material with a support sheet>

The release film was peeled off from the film-shaped firing material with a support sheet; by the use of a tape mounter (Adwill RAD2500, available from Lintec Corporation), the surface on the exposed side of the film-shaped firing material was adhere to the treated surface of a silicon adherend member (diameter: 150 mm, thickness: 500 μm, available from Science & Technology Inst., Co.) having a surface with an arithmetic average roughness (Ra) of 0.02 μm or less by way of chemical mechanical polishing treatment. The silicon wafer, to which the obtained film-shaped firing material sheet with a support sheet is affixed, was mounted on a ring frame for dicing (available from Disco Corporation); by the use of a dicing device (DFD-651, available from Disco Corporation), dicing by cutting from the silicon adherend side was performed under the following dicing conditions, dividing the silicon wafer into chips having a size of 5 mm × 5 mm. For the chips obtained by dicing, the presence of chips fell off from the support sheet during dicing was confirmed. A means the case in which there was no presence of fallen chips, while B means the case in which there was presence of fallen chips. The results are shown in Table 1.

<Various conditions>

- Dicing blade: NBC-ZH2050-SE27HECC, available from Disco Corporation
- Blade thickness: 0.03 mm
- Blade drawing amount: 0.76 mm
- Blade rotation speed: 40000 rpm
- Cutting speed: 40 mm/sec
- Cut depth into base material of support sheet: 20 $\mu$m
- Amount of cutting water: 1.0 L/min
- Temperature of cutting water: 20°C

<Evaluation of exudability of film-shaped firing material>

The film-shaped firing material described above having the same size as a 2 mm semiconductor chip was applied to the back surface of the semiconductor chip, resulting in a semiconductor chip with film-shaped firing material. The release film of the film-shaped firing material was peeled off; with the surface of the film-shaped firing material facing down and pressed on a copper substrate at 50°C and 5 MPa, the presence of exudation from the edge of the chip was evaluated. Exudation was observed with a digital microscope (VHX-5000, available from Keyence Corporation). A means an exudation with a maximum distance of less than 150 $\mu$m from the edge of the chip, while B means an exudation with a maximum distance of 150 $\mu$m and greater.

Table 1

| | | Example 1 | Example 2 | Example 3 | Comparative Example 1 | Comparative Example 2 |
|---|---|---|---|---|---|---|
| Binder component (mass%) | | 5.0 | 5.0 | 4.9 | 10.0 | 5.0 |
| Metal particles (mass%) | | 94.5 | 94.0 | 93.6 | 90.0 | 95.0 |
| Liquid component (mass%) | | 0.5 | 1 | 1.5 | - | - |
| Peel strength [N/ 25 mm] | To wafer (a1) | 0.8 | 1.3 | > 1.5 (cohesion failure) | > 1.5 (cohesion failure) | 0.1 |
| | To support sheet (a2) | 0.2 | 0.25 | 0.3 | 0.4 | 0.06 |
| Dicing evaluation | | A | A | A | A | B |
| Exudability evaluation | | A | A | A | B | A |

In Comparative Example 1, when the chip, which is an individual piece resulting from dicing, and the substrate were subjected to sinter bonding with the film-shaped firing material interposed therebetween, exudation of the film-shaped firing material from between the chip and the substrate was confirmed, and the exudability was evaluated as "×". In addition, in Comparative Example 2, in which the content ratio of the binder was reduced compared to that in Comparative Example 1, adhesion between the film-shaped firing material and the support sheet was insufficient, and dicing defects had occurred.

Meanwhile, in Examples 1 to 3 containing the liquid component according to the present invention, adhesion between the film-shaped firing material and the dicing tape was sufficient; in addition, when the chip, that is an individual piece resulting from dicing, and the substrate were subjected to sinter bonding with the film-shaped firing material interposed therebetween, exudation of the film-shaped firing material from between the chip and the substrate did not occur.

Each configuration in each of the embodiments and combinations thereof are examples, and additions, omissions, substitutions, and other changes may be made to the configuration within a range that does not depart from the spirit of the present invention. The present invention is also not limited by each of the embodiments and is limited only by the scope of the claims.

[Reference Signs List]

1: Film-shaped firing material

2:          Support sheet
3:          Base material film
4:          Pressure sensitive adhesive layer
5:          Ring frame
6:          Substrate
10:         Sinterable metal particles
11:         Sintered body
18:         Wafer
19:         Chip
20:         Binder component
30:         Liquid component
100a:       Film-shaped firing material with a support sheet
100b:       Film-shaped firing material with a support sheet
120:        Laminate
130:        Semiconductor chip with film-shaped firing material
140:        Semiconductor device
C:          Cut

**Claims**

1.  A film-shaped firing material comprising sinterable metal particles, a binder component that is a solid at room temperature, and a liquid component that is a liquid at room temperature, the liquid component having a boiling point from 300 to 450°C.

2.  A film-shaped firing material with a support sheet, comprising the film-shaped firing material described in claim 1, and a support sheet provided on at least one side of the film-shaped firing material.

3.  The film-shaped firing material with a support sheet according to claim 2, wherein

    the support sheet includes a pressure sensitive adhesive layer provided on a base material film, and
    the film-shaped firing material is provided on the pressure sensitive adhesive layer.

4.  A laminate, in which the film-shaped firing material with a support sheet described in claim 2 or 3 is affixed to a wafer, the laminate comprising the support sheet, the film-shaped firing material, and the wafer, which are laminated in this order.

5.  A method for producing a device comprising:

    affixing a semiconductor chip with a film-shaped firing material to a surface of a substrate, the semiconductor chip with a film-shaped firing material being obtained by affixing a semiconductor chip to the film-shaped firing material described in claim 1; and
    firing and pressurizing the film-shaped firing material of the semiconductor chip to bond the semiconductor chip with the film-shaped firing material to the substrate.

6.  A method for producing a device comprising:

    dicing the semiconductor wafer and the film-shaped firing material of the laminate described in claim 4;
    peeling the diced film-shaped firing material off from the support sheet to obtain a semiconductor chip with the film-shaped firing material;
    affixing the semiconductor chip with the film-shaped firing material to a surface of a substrate, and
    firing and pressurizing the film firing material of the semiconductor chip with the film-shaped firing material to bond the semiconductor chip with the film-shaped firing material to the substrate.

# FIG. 1

# FIG. 2

# FIG. 3

FIG. 4

FIG. 5

## FIG. 6

(a)

120

18  1
4 } 2
3

(b)

120

19    C

1
4 } 2
3

(c)

71

I ⇑

19 } 130
1

C

C

19

19

1

1

4
1

4 } 2
3

70

(d)

19 } 130
1

6

(e)

140

19

11

6

## INTERNATIONAL SEARCH REPORT

International application No.

PCT/JP2020/043381

### A. CLASSIFICATION OF SUBJECT MATTER

B22F 7/08(2006.01)i; B22F 9/00(2006.01)i; B82Y 30/00(2011.01)i; H01L
21/52(2006.01)i
FI:      B22F7/08 C; B22F7/08 G; H01L21/52 E; H01L21/52 C; B82Y30/00;
         B22F9/00 B

According to International Patent Classification (IPC) or to both national classification and IPC

### B. FIELDS SEARCHED

Minimum documentation searched (classification system followed by classification symbols)
B22F7/08; B22F9/00; B82Y30/00; H01L21/52

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2019/069818 A1 (LINTEC CORP.) 11 April 2019 (2019-04-11) claims, paragraphs [0018], [0114] | 1-6 |

☐ Further documents are listed in the continuation of Box C.   ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 January 2021 (06.01.2021) | 19 January 2021 (19.01.2021) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

Information on patent family members

International application No.

PCT/JP2020/043381

| Patent Documents referred in the Report | Publication Date | Patent Family | Publication Date |
|---|---|---|---|
| WO 2019/069818 A1 | 11 Apr. 2019 | TW 201922984 A claims | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019211632 A
- JP 2014111800 A